# EUROPÄISCHE PATENTSCHRIFT

(11) **EP 1 798 306 B1**
(45) Veröffentlichungstag und Bekanntmachung des Hinweises auf die Patenterteilung: **11.06.2008**
(21) Anmeldenummer: 05026703.8
(22) Anmeldetag: 07.12.2005
(51) Int. Cl.: C23C 14/12, C23C 14/24

(54) **Verfahren zum Abscheiden eines Aufdampfmaterials**
Method of vapour deposition
Procédé de déposition en phase vapeur

(43) Veröffentlichungstag der Anmeldung: 20.06.2007
(60) Teilanmeldung: 08006787.9
(73) Patentinhaber: Novaled AG, 01307 Dresden (DE)
(72) Erfinder: Birnstock, Jan, Dr., 01187 Dresden (DE); Ansgar , Werner, Dr., 01277 Dresden (DE); Hofmann, Michael, Dipl. Phys., 01187 Dresden (DE)
(74) Vertreter: Bittner, Thomas L.

(56) Entgegenhaltungen:
- US-A- 3 913 999
- US-A1- 2005 016 461
- PATENT ABSTRACTS OF JAPAN Bd. 008, Nr. 118 (C-226), 31. Mai 1984 (1984-05-31) -& JP 59 031865 A (NIPPON SHINKU GIJUTSU KK), 21. Februar 1984 (1984-02-21)

## Beschreibung

Die Erfindung betrifft ein Verfahren zum Abscheiden eines Aufdampfmaterials auf einem Basismaterial, insbesondere zum Dotieren eines Halbleitermaterials. Darüber hinaus bezieht sich die Erfindung auf eine Aufdampfcharge sowie ein Verfahren zum Herstellen der Aufdampfcharge.

### Stand der Technik

Eine Vielzahl neuartiger Materialien, die heute in Hochtechnologien Anwendungen finden, ist empfindlich gegenüber einer das Material umgebenden Atmosphäre, also beispielsweise gegen Luft und Feuchtigkeit. Ein Beispiel hierfür sind Materialien, die für organische elektronische Bauelemente wie zum Beispiel organische Leuchtdioden (OLED - "Organische Licht emittierende Diode") eingesetzt werden.

OLEDs sind seit der Demonstration niedriger Arbeitsspannungen von Tang et al. (vgl. C.W. Tang et al., Appl. Phys. Lett. 51 (12), 913 (1987)) aussichtsreiche Kandidaten für die Realisierung von neuartigen Beleuchtungs- oder von Anzeigeelementen. Sie umfassen eine Folge dünner Schichten aus organischen Materialien, welche bevorzugt im Vakuum aufgedampft oder in ihrer polymeren Form aufgeschleudert werden. Nach elektrischer Kontaktierung mittels Metallschichten bilden sie vielfältige elektronische oder optoelektronische Bauelemente, beispielsweise Dioden, Leuchtdioden oder Photodioden. Auch Transistoren lassen sich mit Hilfe der organischen Dünnschichten realisieren. Diese organischen Bauelemente konkurrieren mit den etablierten Bauelementen auf der Basis anorganischer Schichten.

Im Fall der organischen Leuchtdioden wird mittels Injektion von Ladungsträgern, nämlich Elektronen von der einen und Löchern von der anderen Seite, aus den Kontakten in anschließende organische Schichten infolge einer äußeren angelegten Spannung, der folgenden Bildung von Exzitonen (Elektron-Loch-Paare) in einer aktiven Zone und der strahlenden Rekombination dieser Exzitonen, Licht erzeugt und von der Leuchtdiode emittiert.

Der Vorteil solcher Bauelemente auf organischer Basis gegenüber konventionellen Bauelementen auf anorganischer Basis, zum Beispiel Halbleiter wie Silizium, Galliumarsenid, besteht darin, dass es möglich ist, sehr großflächige Elemente herzustellen, also große Anzeigeelemente wie Bildschirme oder Anzeigeflächen. Die organischen Ausgangsmaterialien sind gegenüber den anorganischen Materialien relativ billig. Darüber hinaus können diese Materialien aufgrund ihrer gegenüber anorganischen Materialien geringen Prozesstemperatur auf flexible Substrate aufgebracht werden, was eine ganze Reihe von neuartigen Anwendungen in der Display- und Beleuchtungstechnik eröffnet.

In dem Dokument US 5,093,698 wird eine organische Leuchtdiode vom pin-Typ beschrieben, bei der es sich um eine organische Leuchtdiode mit dotierten Ladungsträgertransportschichten handelt. Insbesondere kommen drei organische Schichten zur Anwendung, die sich zwischen zwei als Elektroden gebildeten Kontakten befinden. N-artig und p-artig dotierte Schichten verbessern hierin die Ladungsträgerinjektion und den Transport sowohl von Löchern als auch Elektronen in der entsprechend dotierten Schicht. Die Energieniveaus HOMO ("Highest Occupied Molecular Orbital") und LUMO ("Lowest Unoccupied Molecular Orbital") sind bevorzugt so gewählt, dass beide Sorten von Ladungsträgern in der Emissionszone "gefangen" werden, um eine effiziente Rekombination von Elektronen und Löchern zu gewährleisten. Die Beschränkung der Ladungsträger auf die Emissionszone wird mittels geeigneter Wahl der lonisationspotentiale / Elektronenaffinitäten für die Emissionsschicht und / oder die Ladungsträgertransportschicht realisiert. Auch die Emissionsschicht kann mit fluoreszenten oder phosphoreszenten Emitterdotanden dotiert werden.

Die aus dem Dokument US 5,093,698 bekannte Bauelementstruktur führt zu einer stark verbesserten Ladungsträgerinjektion aus den Kontakten in die organischen Schichten. Die hohe Leitfähigkeit der dotierten Schichten vermindert zudem den dort auftretenden Spannungsabfall beim Betrieb der OLED. Dotierte Bauelemente können deshalb bei einer gewünschten Leuchtdichte deutlich geringere Betriebsspannungen als vergleichbare undotierte Strukturen benötigen.

Insbesondere die Dotanden für die Elektronentransportschicht sind sehr empfindlich gegen Sauerstoff und Feuchtigkeit. Da diese Moleküle im Fall einer n-Dotierung sehr starke Donatoren sind, reagieren sie zumindest teilweise schon bei Raumtemperatur mit der umgebenden Luft und können danach ihre Funktion in der OLED nicht oder zumindest nicht vollständig erfüllen. Dies gilt sowohl für anorganische n-Dotanden wie Cäsium als auch für organische n-Dotanden wie Decamethylcobaltocen.

Auch von Emitterdotanden ist bekannt, dass sie mit Luftsauerstoff und Feuchtigkeit bei Raumtemperatur reagieren und dadurch die Effizienz der OLED verringert und gegebenenfalls das Spektrum der Lichtemission verschoben ist. Ein Beispiel für ein solches reaktives Material ist der phosphoreszente Emitter Tris(1-phenylisoquinolin)iridium (III). Aber auch andere in organischen Bauelementen eingesetzte Materialien können bei Raumtemperatur mit der umgebenden Atmosphäre reagieren.

Das bedeutet, derartige Materialien müssen während der Herstellung der organischen Bauelemente und auch nach ihrer Fertigstellung vor Umgebungsluft geschützt werden. Da derartige Bauelemente nach ihrer Herstellung gekapselt werden, beispielsweise mittels einer so genannten Dünnschichtverkapselung oder mittels Verkleben mit einer Glas- oder Metallkappe, ist besonders die Herstellung des Bauelementes kritisch. Während dieser wird das luftempfindliche Material in einer Vakuumanlage thermisch verdampft und auf einem Substrat des Bauelementes abgeschieden. Dieser Verfahrensschritt ist für das luftempfindliche Material unkritisch, da er üblicherweise im Vakuum erfolgt und das luftempfindliche Material demzufolge nicht mit Umgebungsluft reagieren kann. Kritisch sind hingegen der Transport des luftempfindlichen Materials zur Vakuumbeschichtungskammer und die Beladung dieser mit dem luftempfindlichen Material. Zumeist ist eine Beladung über eine Inertgas-Glovebox nicht möglich, und daher ist eine Beladung über Umgebungsluft notwendig.

Die Beladung einer herkömmlichen Beschichtungsanlage mit einem Aufdampfmaterial, welches insbesondere gegenüber Luft empfindlich ist, zum Beschichten mittels Verdampfen soll möglichst erfolgen, ohne dass das zu verarbeitende Aufdampfmaterial der Umgebungsluft ausgesetzt ist und ohne dass es einer Modifikation der Beschichtungsanlage bedarf. Herkömmlich wird zu diesem Zweck die Vakuumkammer an eine Glovebox, die mit Inertgas wie zum Beispiel Stickstoff oder Argon befüllt ist, angeschlossen. Dann wird das empfindliche Aufdampfmaterial über die Glovebox in die Kammer geladen. Dieses Vorgehen ist nicht besonders praktikabel, da ein Großteil von Beschichtungsanlagen nicht an eine Glovebox angeschlossen ist und sowohl Anschaffung als auch Wartung einer solchen Glovebox sehr teuer und aufwendig sind.

Alternativ wurde versucht, das Aufdampfmaterial zunächst in Behältnisse zu füllen, die mit einem Inertgas geflutet sind, und dann das Material möglichst schnell in die Vakuumkammer zu bringen und rasch abzupumpen. Bei dieser Vorgehensweise wird zwar der Kontakt zur Umgebungsluft verringert, aber für viele der hochreaktiven Aufdampfmaterialien reicht diese Beladungsprozedur nicht aus. Der kurze Kontakt des empfindlichen Materials mit der Umgebungsluft reicht bereits, dass das Material zumindest teilweise mit dem Sauerstoff oder dem Wasser reagiert.

Eine weitere Alternative besteht darin, eine Quelle für das Aufdampfmaterial zu benutzen, die von der Verdampfungsanlage abzutrennen ist, wobei die Quelle nach Abnahme gasdicht verschlossen sein muss. Dann lässt sich die Quelle in einer Glovebox unter Inertgas mit dem luftempfindlichen Aufdampfmaterial befüllen, luftdicht verschließen, aus der Glovebox ausschleusen und wieder an die Beschichtungsanlage anschließen. Sobald kein Sauerstoff oder Wasser mehr in der Vakuumanlage ist, wird die Trennung zwischen Quelle und Beschichtungsanlage aufgehoben, und der Aufdampfprozess kann beginnen, ohne dass das luftempfindliche Material hätte reagieren können. Nachteil dieser Variante ist, das derartige Quellen kaum verbreitet sind. Sie sind teuer, und die Ladeprozedur ist aufwendig.

Zum Abscheiden eines Aufdampfmaterials ist ein Verfahren bekannt (vgl. Patentzusammenfassung von JP 59031865), bei dem eine Aufdampfcharge eines Aufdampfmaterials in einem Behälter angeordnet wird, welcher dann mit einem Deckel dicht verschlossen wird. Der Deckel ist aus einem Material, welches mittels Erwärmen oder innerem Druck aufgebrochen werden kann. Beispielsweise kann ein dünner Film aus Quarz genutzt werden. Zum Verdampfen der Aufdampfcharge des Aufdampfmaterials beim Abscheiden wird die Aufdampfcharge mit Laserlicht bestrahlt.

### Die Erfindung

Aufgabe der Erfindung ist es, ein Verfahren zum Abscheiden eines Aufdampfmaterials auf einem Basismaterial, insbesondere zum Dotieren eines Halbleiters, bei dem die prozeßgerechte Handhabbarkeit des Aufdampfmaterials erleichtert ist. Weiterhin sollen eine Aufdampfcharge mit verbesserter Handhabbarkeit sowie ein Verfahren zum Herstellen der Aufdampfcharge geschaffen werden.

Diese Aufgabe wird erfindungsgemäß durch ein Verfahren zum Abscheiden eines Aufdampfinaterials auf einem Basismaterial nach dem unabhängigen Anspruch 1, eine Aufdampfcharge nach dem unabhängigen Anspruch 5 sowie ein Verfahren zum Herstellen einer Aufdampfcharge nach dem unabhängigen Anspruch 10 gelöst.

Das Aufdampfmaterial ist reaktiv, insbesondere luftempfindlich. Es besteht eine Empfindlichkeit gegenüber einem oder mehreren von Luft umfaßten Gasen und / oder Gasgemischen. Alternativ oder in Ergänzung hierzu kann eine Empfindlichkeit gegenüber Feuchtigkeit vorliegen.

Die Erfindung hat gegenüber dem Stand der Technik den Vorteil, dass die Handhabung eines Aufdampfinaterials vereinfacht ist und trotzdem ein sachgerechter Umgang mit dem Aufdampfmaterial vor dem Verdampfen gewährleistet ist, indem das Aufdampfmaterial gegenüber der Umgebung abgeschirmt ist. Auf diese Weise wird die Qualität des Aufdampfmaterials aufrechterhalten, und der Transport und die Lagerung werden erleichtert. Ein luftdichter Einschluß im Sinne der Erfindung liegt insbesondere auch dann vor, wenn durch die Hülle hindurch in geringem Umfang eine Permeation von Wasserdampf möglich ist.

Es ist einerseits ein zuverlässiges, luftdichtes Einschließen des Aufdampfmaterials gewährleistet, und andererseits wird ein leichtes Öffnen der Hülle zum Zweck des Verdampfens des Aufdampfmaterials ermöglicht. Es ist eine klare Trennung der Prozeßschritte zum Öffnen der Hülle und nachfolgenden Verdampfen des Aufdampfmaterials gewährleistet.

Als schmelzbares Hüllenmaterial wird beispielsweise eine Legierung oder ein Metall verwendet. Derartige Materialien mit niedriger Schmelztemperatur sind als solche in verschiedenen Ausführungsformen bekannt, sodass eine zweckmäßige Auswahl für bestimmte Anwendungsfälle getroffen werden kann. Grundsätzlich kann die Hülle zum Einschließen des Aufdampfmaterials vollständig oder nur teilweise aus dem schmelzbaren Hüllenmaterial gebildet sein.

Es kann vorgesehen sein, daß die Hülle über einen Abschnitt aus einem Bimetall oder einem Federstahl verfügt, welcher als eine Art Deckel oder öffenbare / verschließbare Öffnung dient. In ähnlicher Weise kann eine alternative Ausgestaltung der Erfindung die Verwendung eines Materials, insbesondere eines Metalls oder einer Legierung, mit einem Formgedächtnis vorsehen. Hierbei wird ein "thermischer Gedächtniseffekt" zum Öffnen / Schließen der Hülle genutzt.

Bei einer Weiterbildung der Erfindung kann vorgesehen sein, dass die Hülle im Bereich eines als Folie gebildeten Hüllenabschnittes geöffnet wird. Folien lassen sich mit Hilfe verschiedenster Verarbeitungsverfahren verarbeiten und werden in verschiedenen Anwendungen zum luftdichten Verpacken oder Verkapseln von Materialien verwendet. Darüber hinaus erlaubt die Verwendung einer Folie ein mit wenig Aufwand ausführbares Öffnen der Hülle zum Zweck des Verdampfens des Aufdampfmaterials.

Um nicht gewollte Reaktionen des Aufdampfmaterials vor dem Abscheiden mit anderen chemischen Stoffen oder Verbindungen zu vermeiden, ist bei einer zweckmäßigen Ausgestaltung der Erfindung vorgesehen, dass in dem Aufdampfraum beim Verdampfen und beim Abscheiden des Aufdampfinaterials eine Vakuumumgebung oder eine Inertgasatmosphäre aufrechterhalten wird.

Für abhängige Unteransprüche betreffend eine Aufdampfcharge sowie ein Verfahren zum Herstellen der Aufdampfcharge gelten die in Verbindung mit abhängigen Unteransprüchen des Verfahrens zum Abscheiden eines Aufdampfmaterials mit zugehörigen Merkmalen erläuterten Vorteile entsprechend.

Bei der Aufdampfcharge ist in einer zweckmäßigen Ausgestaltung der Erfindung die Hülle mittels Kleben, Kaltformen, Schweißen oder Löten geschlossen. Die Prozesse des Kaltformens umfassen insbesondere auch das Quetschen zum Schließen der Hülle.

Eine vorteilhafte Weiterbildung der Erfindung kann vorsehen, dass bei der Aufdampfcharge die Hülle wenigstens teilweise von einem Tiegel gebildet ist, aus dem heraus das Aufdampfmaterial zum Abscheiden verdampft werden kann. Hierdurch kann ein an das Aufdampfmaterial angepaßter Tiegel beim Abscheiden verwendet werden, ohne dass es einer Anpassung der Beschichtungsanlage bedarf, da der Tiegel zusammen mit dem Aufdampfinaterial in der Beschichtungsanlage eingebracht werden kann.

Bei einer Ausgestaltung der Erfindung ist vorgesehen, dass an dem Tiegel eine Aufnahmeeinrichtung zum Aufnehmen wenigstens eines Hüllenabschnittes gebildet ist, welcher beim Öffnen der Hülle aufgebrochen wird. Auf diese Weise ist es ermöglicht, dass beim Herausnehmen des Tiegels aus der Beschichtungsanlage nach dem Abscheiden gleichzeitig die Reste der aufgebrochenen Hülle entsorgt werden. Beispielsweise kann vorgesehen sein, dass die Aufnahmeeinrichtung einen sich beim Aufschmelzen der Hülle zusammenziehenden Hüllenabschnitt aufnimmt.

Im Zusammenhang mit dem Herstellen der Aufdampfcharge, bei der das Aufdampfinaterial von der Hülle luftdicht umgeben wird, sieht eine Fortbildung der Erfindung vor, dass beim Einschließen der Chargenmenge des Aufdampfmaterials ein die Chargenmenge aufnehmender Raum evakuiert und / oder mit einem Inertgas gefüllt wird, so dass zuverlässig gewährleistet ist, dass in dem von der Hülle umgebenen Raum keine Luft verbleibt.

### Bevorzugte Ausführungsbeispiele der Erfindung

Die Erfindung wird im folgenden anhand von Ausführungsbeispielen unter Bezugnahme auf Figuren einer Zeichnung näher erläutert. Hierbei zeigen:
- Fig. 1: eine schematische Darstellung einer Aufdampfcharge im Querschnitt, bei der eine Chargenmenge des Aufdampfmaterials von einer Hülle luftdicht eingeschlossen ist;
- Fig. 2: eine schematische Darstellung einer Aufdampfcharge, bei der eine Chargenmenge des Aufdampfmaterials in einem Tiegel angeordnet ist, welcher luftdicht abgeschlossen ist;
- Fig. 3: eine schematische Darstellung einer Aufdampfcharge, bei der eine Chargenmenge des Aufdampfmaterials in einem kastenförmigen Tiegel luftdicht eingeschlossen ist;
- Fig. 4: eine schematische Darstellung einer Anordnung von mehreren zusammenhängend gebildeten Aufdampfchargen, bei denen für mehrere Chargenmengen eine einteilige Hülle gebildet ist;
- Fig. 5: eine schematische Darstellung der Aufdampfcharge nach Fig. 2 im Querschnitt im geschlossenen Zustand und geöffneten Zustand;
- Fig. 6: eine schematische Darstellung einer Aufdampfcharge im Querschnitt, bei der eine Hülle zur Aufnahme einer Chargenmenge des Aufdampfmaterials mit einem Deckel versehen ist;
- Fig. 7: eine schematische Darstellung einer Aufdampfcharge im Querschnitt, bei der eine Hülle aus zwei Halbkugelschalen gebildet ist; und
- Fig. 8: die chemische Strukturformel von Cr(hpp)₄.

Ein empfindliches Material zum Aufdampfen, welches im folgenden auch als Aufdampfmaterial bezeichnet wird, wird nach seiner Herstellung und vor der Verwendung zum Abscheiden mittels einer Beschichtungs- oder Aufdampfanlage in einer Hülle luftdicht eingeschlossen, wodurch eine Aufdampfcharge gebildet ist, welche eine luftdichte abgeschlossene Chargenmenge des aufzudampfenden Materials in einer auch als Verkapselung bezeichenbaren Hülle enthält. Ein luftdichter Einschluß im Sinne der Erfindung liegt insbesondere auch dann vor, wenn durch die Hülle hindurch in geringem Umfang eine Permeation von Wasserdampf möglich ist. Bevorzugt ist die Permeation von Wasserdampf auf maximal etwa 100 bis 1000 g pro m² und Tag begrenzt

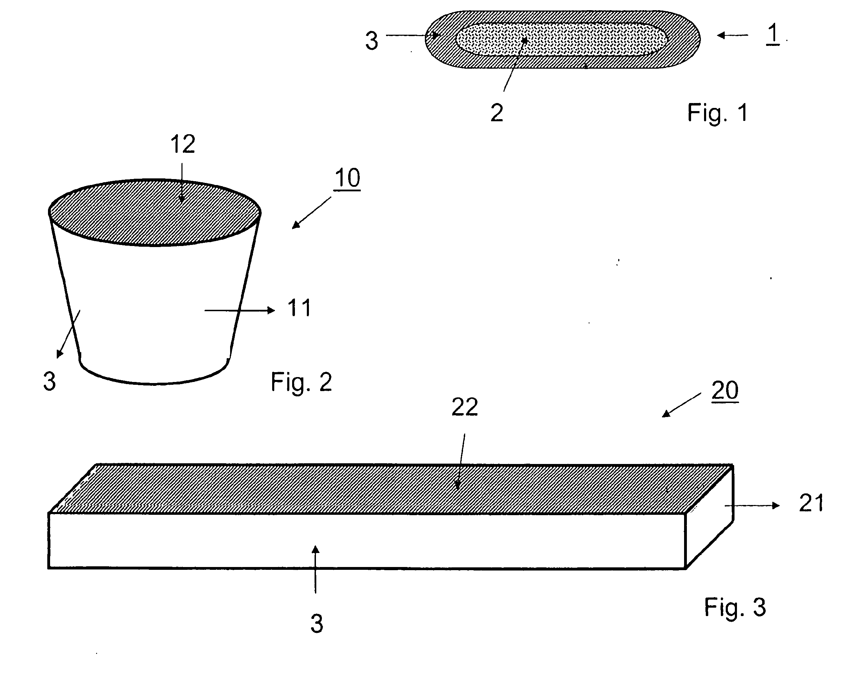

Fig. 1 zeigt eine schematische Darstellung einer Aufdampfcharge 1 im Querschnitt, bei der eine Chargemenge 2 des Aufdampfmaterials in einer Hülle 3 luftdicht eingeschlossen ist. Die Herstellung der Aufdampfcharge 1 wird zum Beispiel in einer Glovebox unter Inertgasatmosphäre oder im Vakuum ausgeführt, beispielsweise mittels Einschweißen in ein inertes Hüllenmaterial, das bei einer Temperatur schmilzt, die niedriger als eine Aufdampftemperatur des aufzudampfenden Materials ist.

Die so gebildete Aufdampfcharge 1 wird dann beim Abscheiden des Aufdampfinaterials in einen Aufdampftiegel in einer Beschichtungs- oder Aufdampfkammer einer Abscheidungs- oder Beschichtungsanlage (nicht dargestellt) gegeben. Danach wird die Beschichtungskammer abgepumpt. Beim Herstellen der Aufdampfcharge 1 sollte darauf geachtet werden, dass möglichst wenig Inertgas mit verkapselt wird, da sonst während des Abpumpens aufgrund des Überdrucks im von einer Hülle 3, die als eine Art Verkapselung ausgeführt ist, umgebenen Inneren der Aufdampfcharge 1 eine Kraft auf das Hüllenmaterial wirkt, welche die Hülle 3 zerstören könnte. Sind nur geringe Mengen Inertgas innerhalb der Hülle 3, wird ein Aufbrechen der Verkapselung während des Abpumpens vermieden.

In einem weiteren Schritt wird bei dem Ausführungsbeispiel zum Abscheiden des Aufdampfmaterials dann der Aufdampftiegel beheizt, um das Aufdampfmaterial zu verdampfen. Hierbei schmilzt bei der Schmelztemperatur, die kleiner als eine Aufdampftemperatur des Aufdampfmaterials ist, das Hüllenmaterial und gibt so das Aufdampfmaterial frei. Das so freigesetzte Aufdampfmaterial, da nun bereits im Vakuum befindlich, reagiert chemisch nicht, sondern wird beim Erreichen seiner Aufdampftemperatur verdampfen und anschließend auf einem zu beschichtenden Substrat abgeschieden. Auf diese kann beispielsweise ein Halbleitersubstrat dotiert werden.

Als Materialien für die Hülle zum luftdichten Einschluß des Aufdampfmaterials kommen in den verschiedenen Ausführungsformen der Erfindung Materialien in Frage, die über eine oder mehrere der folgenden Eigenschaften verfügen:
- niedriger Dampfdruck in der festen Phase,
- niedriger Dampfdruck in der flüssigen Phase,
- keine chemische Reaktion mit dem Aufdampfmaterial, auch nicht bei hohen Temperaturen,
- eine Schmelztemperatur des Materials zum Einhüllen ist niedriger als eine Aufdampftemperatur des Aufdampfmaterials,
- geringe Benetzung des Aufdampftiegels und des Aufdampfinaterials,
- mechanische Eigenschaften des Materials für die Hülle, insbesondere ein Material, was nicht zu spröde oder zu brüchig ist, erlauben das luftdichte Einschließen des Aufdampfmaterials,
- keine oder geringe Durchlässigkeit für oder Permeation von Sauerstoff, Luft und Wasserdampf
- preiswertes oder wieder verwendbares Material,
- ökologisch unbedenkliches Material.

Beispielsweise können Materialien aus den folgende Materialklassen verwendet werden:
- Metalllegierungen, zum Beispiel Indalloy 57 aus 50 % Wismut, 30% Blei und 20 % Zinn mit einer Schmelztemperatur etwa 100°C,
- Metalle mit niedriger Schmelztemperatur, zum Beispiel Indium mit einer Schmelztemperatur von etwa 156 °C,
- niedrig-schmelzende Glaslote, zum Beispiel DM2700 mit einer Schmelztemperatur von etwa 300°C.

Metalllegierungen mit niedrigem Schmelzpunkt sind eine Materialklasse, die besonders geeignet ist für die vorgeschlagene Einhüllung, da verschiedene bei sehr niedrigen Temperaturen schmelzende Metalllegierungen existieren. Insbesondere kann es sich um niedrig-schmelzende Legierungen handeln, also um Legierungssysteme von Metallen, deren Schmelztemperatur deutlich unterhalb der Schmelztemperatur der Ausgangsmetalle liegt. Beispielsweise schmilzt ein Gemisch von Wismut 49%, Blei 18%, Zinn 12% und Indium 21% bei einer Temperatur von 58°C. Ein Gemisch von Wismut 58% und Zinn 42% dagegen bei 138°C. Beide Gemische sind eutektisch, das bedeutet sie haben eine wohl definierte Schmelztemperatur. Andere Metalllegierungen, wie zum Beispiel Wismut 60% und Zinn 40%, schmelzen in einem Temperaturbereich, hier in einem Bereich von 138°C bis 170°C. Beide Klassen von Metalllegierungen sind für die Verkapselung der luftempfindlichen Materialien geeignet.

Das Schmelzen von Glasloten setzt typischerweise etwas höher ein, nämlich beispielsweise bei 300°C oder höher. Da auch in diesem Temperaturbereich zahlreiche Materialien, die in optoelektronischen Bauteilen angewendet werden, aufgedampft werden, zum Beispiel CuPc oder ZnPc, kann auch diese Materialklasse für die Verkapselung von Aufdampfmaterialien verwendet werden.

Von den reinen Metallen sind neben dem bereits genannten Indium, unter anderem auch noch Gallium (Schmelztemperatur 30°C), Zinn (232°C), Thallium (304°C), Blei (327°C) und Zink (419°C) als Hüllenmaterial geeignet.

Die zur Verkapselung genutzte Hülle kann in den beschriebenen Ausführungsformen und allgemein aus einem oder mehreren Materialien gebildet sein, also beispielsweise ausschließlich aus einem schmelzenden Material. Auch die angeführten Materialbeispiele können unabhängig von der konkreten Ausführungsform, in welcher sie hier vorgestellt werden, mit anderen Ausführungsformen kombiniert werden.

Fig. 2 zeigt eine schematische Darstellung einer Aufdampfcharge 10, bei der eine Chargenmenge eines Aufdampfmaterials in einem Tiegel 11 angeordnet ist, welcher mittels eines als Folie gebildeten Hüllenabschnittes 12 aus einem niedrig-schmelzenden Material luftdicht verschlossen ist. Zum Herstellen der Aufdampfcharge 10 wird die Chargenmenge des Aufdampfmaterials in einer Glovebox (nicht dargestellt) direkt in den Tiegel 11 gefüllt, der dann mittels der Folie, die beispielsweise aus Indium ist, verschlossen wird, wobei die Folie zum Beispiel mittels Löten oder Kleben an dem Tiegel 11 befestigt wird, wie es in ähnlicher Weise beim Verschließen eines Joghurtbechers oder einer Medikamentenpackung grundsätzlich bekannt ist.

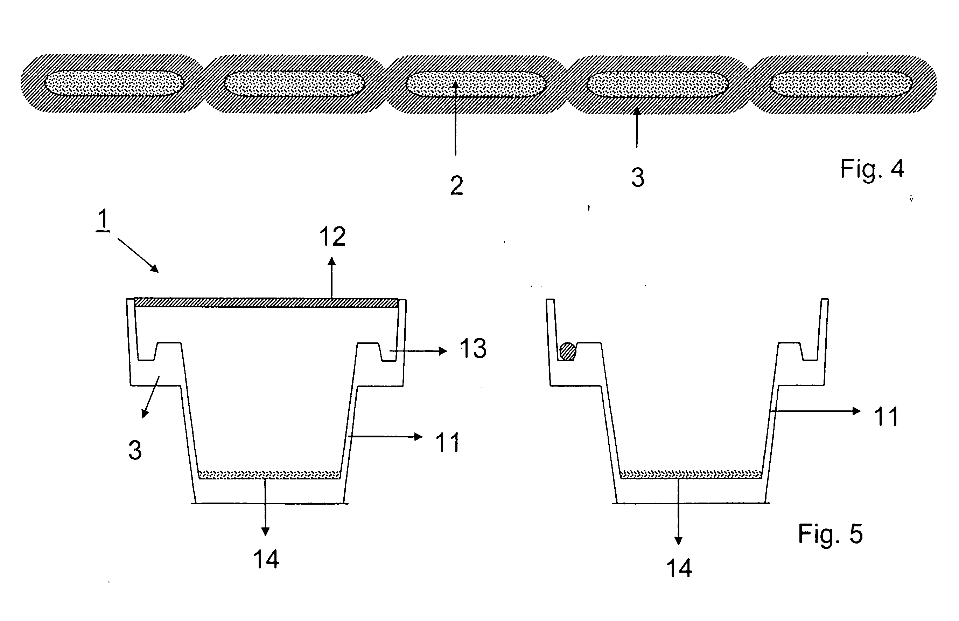

Häufig werden heutzutage Aufdampfmaterialien nicht mehr aus so genannten Punktquellen, sondern aus Linearquellen aufgedampft. Auch in diesem Fall ist eine Verkapselung oder Einhüllung in der vorgeschlagenen Art und Weise nutzbar. Fig. 3 zeigt eine schematische Darstellung einer Aufdampfcharge 20, bei der eine Chargenmenge eines Aufdampfmaterials in einer als kastenförmiger Tiegel 21 ausgebildeten Linearquelle angeordnet ist, wobei der kastenförmige Tiegel 21 mittels eines als Deckel gebildeten Hüllenabschnittes 22 luftdicht verschlossen ist. Der Hüllenabschnitt 22 ist aus einem niedrig-schmelzenden Material und beispielsweise mittels Löten oder Kleben aufgebracht. Es kann auch vorgesehen sein, eine Aufdampfcharge mit einer gewünschten Länge als Linearquelle zu bilden, bei das Aufdampfmaterial von einer Hülle aus dem niedrig-schmelzenden Material luftdicht umgeben ist. Hierbei kann vorgesehen sein, nur eine einzige Materialkammer mit der Chargenmenge des Aufdampfmaterials auszubilden, oder das luftempfindliche Material auf mehrere Kammern aufzuteilen, wie dies in Fig. 4 schematisch dargestellt ist, wodurch die Homogenität der Verteilung des aufzudampfenden Materials in der Linearquelle verbessert wird.

Es kann vorgesehen sein, das Material für die Hülle und / oder den Tiegel vor dem Verkapseln des luftempfindlichen Materials für eine gewisse Zeitdauer, zum Beispiel 1h, bei einer gewissen Temperatur, die möglichst hoch, aber kleiner als die Schmelztemperatur des Hüllenmaterials ist, auszuheizen, um Wasser, das sich daran festgesetzt hat, auszutreiben.

Um die Verkapselung oder Einhüllung des luftempfindlichen Materials gasdicht zu bilden, kommen neben den bisher erwähnten Verfahren des Klebens und des Lötens noch weitere Verfahren in Frage, die mit erhöhter Temperatur arbeiten und vom Erweichen des Materials unter erhöhter Temperatur Gebrauch machen. Ferner kommen auch Verfahren in Frage, die auf der Kaltformung des Hüllenmaterials beruhen, wie zum Beispiel Kaltwalzen, Kaltschweißen oder Nieten.

Da einige der für die Hülle in Frage kommenden niedrig-schmelzenden Materialien nicht sehr preisgünstig sind, kann wahlweise deren Wiederverwertung vorgesehen sein. Das heißt, nach Beendigung des Abscheidens sind die dann im Aufdampftiegel verbliebenen Hüllenmaterialien zu entnehmen, wahlweise aufzureinigen, beispielsweise mittels Einschmelzen, und dann für weitere Verkapselungen wieder zu verwenden. Hierfür kann eine besondere Ausgestaltung des Tiegels vorgesehen sein.

Fig. 5 zeigt eine schematische Darstellung der Aufdampfcharge nach Fig. 2 im Querschnitt im geschlossenen Zustand und geöffneten Zustand. Der Tiegel 11 ist im geschlossen Zustand mit dem als Deckel ausgeführten Hüllenabschnitt 12 aus dem niedrig-schmelzenden Material verschlossen. Wenn beim Erwärmen in der Beschichtungsanlage das Material des Hüllenabschnittes 12 schmilzt, zieht dieses sich aufgrund der Oberflächenspannung zusammen und fällt in Form von Kügelchen in den Tiegel 11 hinein. Dort wird es von einer Auffangrinne 13 aufgefangen und kommt daher gar nicht erst in Kontakt mit einer Chargenmenge 14 des Aufdampfmaterials. Hierdurch kann zuverlässig ausgeschlossen werden, dass das Material des Hüllenabschnittes 12 und das Aufdampfmaterial miteinander reagieren, selbst wenn das Hüllenmaterial nicht völlig inert ist. Die Auffangrinne 13 ist eine mögliche Ausführungsform für eine Auffangeinrichtung zum Aufnehmen von Resten der Hülle, wenn diese beim Aufdampfen des Aufdampfmaterials aufgebrochen wird.

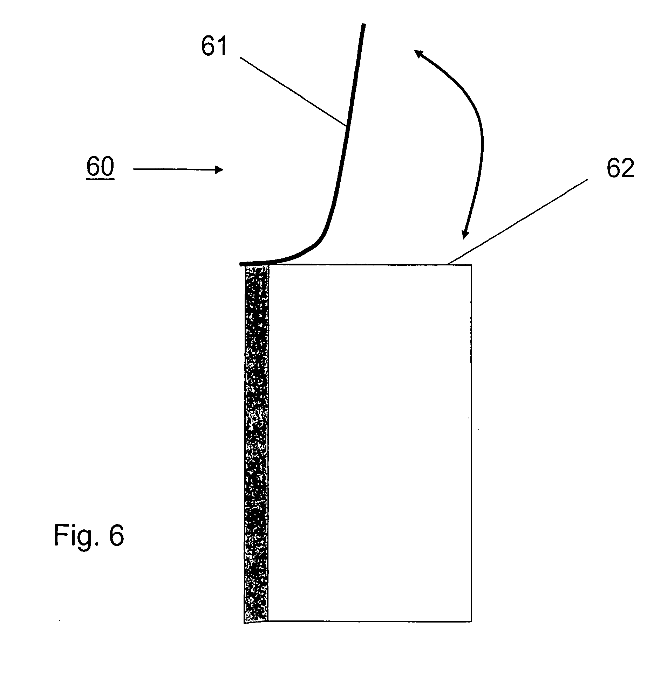

Es kann auch vorgesehen sein, dass sich die Hülle für das luftempfindliche Material beim Abkühlen selber wieder verschließt. Gemäß Fig. 6 weist eine Hülle 60, in der das luftempfindliche Material aufgenommen ist, einen Deckel 61 aus einem Bimetall auf. Aufgrund der Einwirkung von Wärme, entweder beim Erhitzen des Deckels 61 selbst oder der Hülle 60, während der Aufheizphase in Vorbereitung der Abscheidung tritt wegen der unterschiedlichen Wärmeausdehnungskoeffizienten eine Scherspannung auf, die das Bimetall so verformt, dass aus einer Öffnung 62 nun das zu verdampfende Material austreten kann. Wahlweise kann auch nur ein Teil des Deckels 61 aus Bimetall bestehen, beispielsweise eine Verbindungslasche, der die thermische Verformung vollzieht und so den Deckel 61 anhebt und die Hülle öffnet. Schichten des Bimetallelementes sind so angeordnet, dass die Verbiegung zum Öffnen führt. Beim Abkühlen geht das Bimetallelement in seine ursprüngliche Form zurück und verschließt die Öffnung. Dieser Vorgang kann mittels thermischer Einwirkung reversibel gestaltet sein.

Ein ähnlicher in-situ nicht reversibler, aber wiederholbarer Mechanismus kann auch mittels Formgedächtnislegierungen ("*memory alloys*", zum Beispiel Nickel-Titan-Legierung "Nitinol") realisiert werden. Hierbei ist der Verschluss der Hülle oder von Bestandteilen hiervon (vgl. Fig. 6) aus einer Formgedächtnislegierung hergestellt. Es wird der "thermische Gedächtniseffekt" genutzt, dem eine abrupte Umordnung des Metallgitters der Legierung bei einer bestimmten Temperatur (bei Nitinol etwa 50°C) zu Grunde liegt. Der Deckel oder Teile hiervon werden bei einer Temperatur oberhalb des Metallgitterumformpunktes so gestaltet, dass die Hülle, in die das zu verdampfende Material aufgenommen werden soll, geöffnet ist. Während der anschließenden Abkühlphase vollzieht zwar das Metallgitter eine Umorientierung, die äußere Gestalt des Bauteils bleibt aber erhalten. Nun kann das luftempfindliche Material unter Schutzgasatmosphäre eingefüllt werden, und die Öffnung schließt mittels Verbiegen des Verschlusses aus einer Formgedächtnislegierung. Während der Hochheizphase der Verdampfungsquelle wird beim Überschreiten der kritischen Temperatur zur Metallgitterumformung eine Formveränderung ausgelöst, was bewirkt, dass der Verschluss in seine ursprüngliche Ausgangsform vor dem Verbiegen zurückgeht, d. h. dass die Hülle nun wieder geöffnet ist und die Verdampfung des luftempfindlichen Materials unter Vakuum erfolgen kann.

Die Hülle kann nach dem Befüllen evakuiert werden, so dass der Deckel, der beispielsweise aus Federstahl oder aus einem Bimetall oder einer Formgedächtnislegierung ist, aufgrund des äußeren Überdrucks besonders gut abdichtet. Während des Abpumpens der Vakuumverdampfungskammer nimmt die Druckdifferenz stetig ab, so dass entweder der elastisch verformbare Deckel sich sofort öffnet, oder wie oben beschrieben, die anschließende Erwärmung während der Heizphase zur Umformung / Öffnung führt.

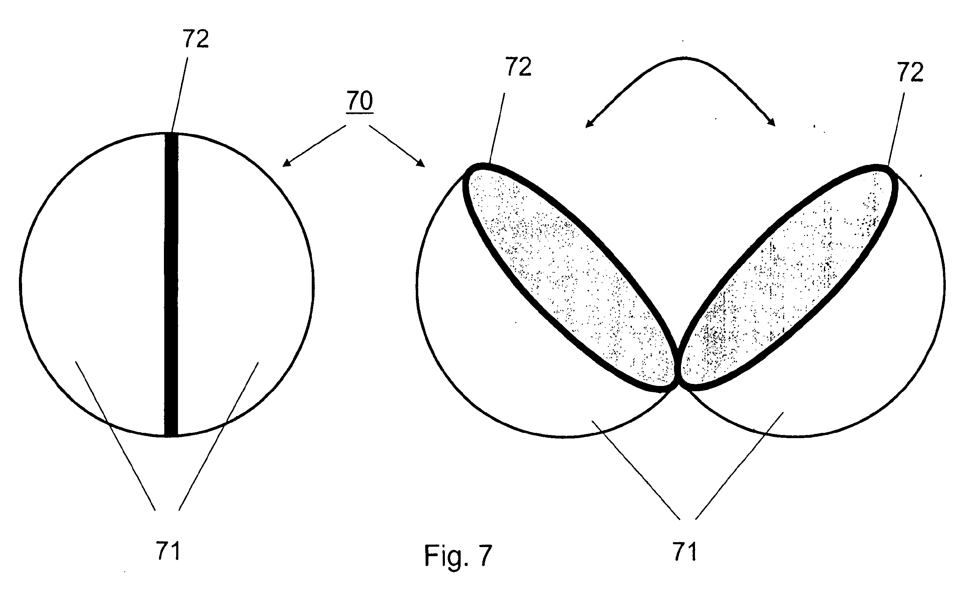

Fig. 7 zeigt ein weiteres Ausführungsbeispiel. Zwei einseitig geöffnete Hohlkörper, hier zwei Halbkugelschalen 71, aus einem luftdichten Material, in die unter Schutzgasatmosphäre das luftempfindliche Material eingefüllt wurde, werden danach mittels einer Legierung 72 an den Kreisrändern luftdicht miteinander verbunden. Mittels thermischem Wärmeeintrag schmilzt eine Verbindungsnaht aus der Legierung 72 unterhalb der Verdampfungstemperatur des luftempfindlichen Materials, so dass die Halbkugelschalen 71 auseinanderklappen und das hierin befindliche Material beim Erreichen der Verdampfungstemperatur sublimiert und auf einem Substrat abgeschieden werden kann. Die Abdichtung gegenüber Luft und Feuchtigkeit kann auch nur mittels Zusammenfügen der beiden Halbkugelschalen 71 und hierauf folgendem Evakuieren des Hohlraumes gewährleistet sein. Wie bereits oben beschrieben, öffnet sich dann diese Anordnung während des Abpumpens der Vakuumverdampfungskammer selbstständig, sobald der Druck innerhalb der Verdampfungskammer unter den innerhalb der Kugelschalen herrschenden Druck fällt.

Im folgenden wird die Erfindung, insbesondere hinsichtlich der unter Bezugnahme auf die Fig. 1 bis 5 erläuterten Merkmale, anhand von weiteren Ausführungsbeispielen detaillierter erläutert.

In einer Ausführungsform zum Herstellen einer Aufdampfcharge werden zwei folienartige Blätter aus der Indalloy 57 mit der Zusammensetzung Bi 50%, Pb 30%, Sn 20% und einem Schmelzpunkt von etwa 100°C verwendet. Ein halbes Gramm Tris(1-phenylisoquinolin)iridium (III) wird zwischen die zwei Blätter der Folie angeordnet, und die Ränder der Folie werden verlötet, beispielsweise mit Hilfe eines herkömmlichen Lötkolbens.

Dieses versiegelte "Paket" wurde in einen Keramik-Aufdampftiegel in eine Aufdampfkammer einer Vakuumaufdampfanlage (nicht dargestellt) gelegt. Die Aufdampfkammer wurde abgepumpt bis auf einen Druck von 10⁻⁶mbar. Danach wurde der Keramik-Aufdampftiegel hochgeheizt. Bei einer Temperatur von 280°C wurde eine Aufdampfrate für das Tris(1-phenylisoquinolin)iridium (III) gemessen, welche der in einem Referenzfall entspricht, bei dem das Tris(1-phenylisoquinolin)iridium (III) auf herkömmliche Weise über eine Glovebox und ohne Verkapselung in den Tiegel gefüllt wurde. Mittels dieses Abscheideprozesses wurde eine organische Leuchtdiode mit Hilfe des verkapselten Emitter-Materials hergestellt, die bei einer Spannung von 2.9V eine Lichtemission von 100cd/m² mit CIE-Farbkoordinaten von (0,68; 0,32) zeigte. Diese Werte stimmen sehr gut mit Referenzwerten für organische Leuchtdioden überein, die mit Hilfe des Emittermaterials Tris(1-phenylisoquinolin)iridium (III) hergestellt wurden, wenn das Emittermaterial nicht mit einer luftdichten Hülle verwendet wurde, sondern in herkömmlicher Weise.

Nach der Herstellung der organischen Leuchtdiode wurde der Keramik-Aufdampftiegel des Tris(1-phenylisoquinolin)iridium (III) untersucht. Es zeigte sich, dass die Indalloy 57 als ein Klümpchen im Tiegel verbleibt, während das verbliebene Tris(1-phenylisoquinoline)iridium (III)-Puder separiert im Tiegel lag. Das zeigt auch, dass eine Wiederverwendung des Hüllenmaterials problemlos möglich ist.

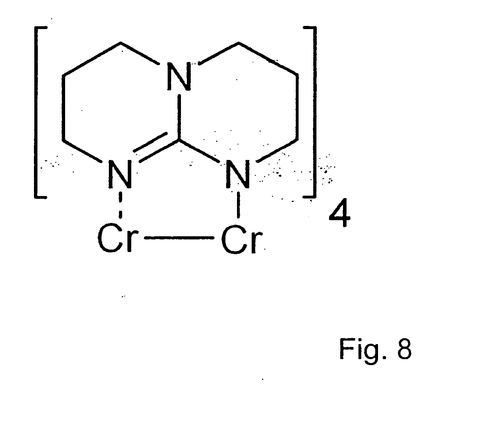

In einem weiteren Ausführungsbeispiel wurde eine Indiumfolie für eine Stunde bei 120°C in einer Glovebox ausgeheizt, um Feuchtigkeit, die sich an der Oberfläche angelagert haben könnte, zuverlässig zu entfernen. Dann wurde aus der Folie ein Umschlag gefaltet, in den der luftempfindliche Dotand Cr(hpp)4 (vgl. Fig. 8) gefüllt wurde. Die Ränder wurden luftdicht kaltverschweißt, indem mit Hilfe einer Zange Druck auf die Ränder ausgeübt wurde. Zwei dieser Umschläge wurden präpariert. Der erste wurde in einen Glaszylinder platziert, der daraufhin abgepumpt wurde. Der Umschlag blähte sich auf, was anzeigt, dass die Verkapselung luftdicht erfolgte. Der Umschlag wurde nicht zerstört. Danach wurde der Zylinder erhitzt, worauf das Indium schmolz und das verkapselte Material freigesetzt wurde, und zwar ohne aufgrund des Druckabfalls im Umschlag weggeblasen zu werden.

Mit Hilfe des zweiten Umschlages wurde eine dotierte Ladungsträger-Transportschicht für eine organische Leuchtdiode hergestellt. Als Matrix für die Ladungsträger-Transportschicht wurde ZnPc verwendet. Die gemessene Leitfähigkeit der dotierten Ladungsträger-Transportschicht lag im Bereich der Leitfähigkeit von Referenzproben, die mit Hilfe eines Dotanden hergestellt wurden, der auf herkömmliche Weise über eine Glovebox und ohne Verkapselung in die Aufdampfkammer geladen wurde.

Die beiden zuletzt beschriebenen Ausführungsbeispiel zeigen, dass insbesondere niedrig-schmelzende Materialien, zum Beispiel Metalle oder Metalllegierungen, geeignet sind, luftempfindliche Materialien, die in einer thermischen Vakuumaufdampf- oder Beschichtungsanlage prozessiert werden sollen, hermetisch gegen die Umgebungsluft abzugrenzen. Derart verkapselte Materialien können anschließend auf herkömmliche Weise verdampft werden, ohne dass Leistungseinbußen auftreten.

Die in der vorstehenden Beschreibung, den Ansprüchen und den Zeichnungen offenbarten Merkmale der Erfindung können sowohl einzeln als auch in beliebiger Kombination für die Verwirklichung der Erfindung in ihren verschiedenen Ausführungsformen von Bedeutung sein.

## Patentansprüche

1. Verfahren zum Abscheiden eines Aufdampfmaterials auf einem Basismaterial, insbesondere zum Dotieren eines Halbleitermaterials, bei dem in einem Aufdampfraum eine Aufdampfcharge (1; 10; 20), bei der das Aufdampfmaterial von einer Hülle (3) luftdicht eingeschlossen ist, eingebracht wird und in dem Aufdampfraum die Hülle (3) geöffnet wird, so dass anschließend das Aufdampfmaterial in dem Aufdampfraum verdampft und auf dem Basismaterial abgeschieden wird, wobei die Hülle (3) geöffnet wird, indem ein die Hülle (3) wenigstens teilweise bildendes und schmelzbares Hüllenmaterial bei einer Schmelztemperatur mittels Erwärmen zumindest teilweise geschmolzen wird, welche geringer ist als eine Verdampfungstemperatur des Aufdampfmaterials.

2. Verfahren nach Anspruch 1, **dadurch gekennzeichnet, dass** als das schmelzbare Hüllenmaterial eine Legierung oder ein Metall verwendet wird.

3. Verfahren nach einem der vorangehenden Ansprüche, **dadurch gekennzeichnet, dass** die Hülle (3) im Bereich eines als Folie gebildeten Hüllenabschnittes geöffnet wird.

4. Verfahren nach einem der vorangehenden Ansprüche, **dadurch gekennzeichnet, dass** in dem Aufdampfraum beim Verdampfen und beim Abscheiden des Aufdampfmaterials eine Vakuumumgebung oder eine Inertgasatmosphäre aufrechterhalten wird.

5. Aufdampfcharge (1; 10, 20) mit einem Aufdampfmaterial zum Abscheiden auf einem Basismaterial, insbesondere zum Dotieren eines Halbleitermaterials, wobei eine Chargenmenge (2; 14) des Aufdampfmaterial von einer Hülle (3) luftdicht eingeschlossen ist, **dadurch gekennzeichnet, dass** die Hülle (3) wenigstens teilweise aus einem zum Öffnen in einem Aufdampfraum mittels Erwärmen schmelzbaren Hüllenmaterial gebildet ist, wobei das schmelzbare Hüllenmaterial eine Schmelztemperatur aufweist, welche geringer ist als eine Verdampfungstemperatur des Aufdampfmaterials.

6. Aufdampfcharge (1; 10, 20) nach Anspruch 5, **dadurch gekennzeichnet, dass** das schmelzbare Hüllenmaterial eine Legierung oder ein Metall ist.

7. Aufdampfcharge (1; 10, 20) nach einem der Ansprüche 5 oder 6, **dadurch gekennzeichnet, dass** die Hülle (3) mittels Kleben, Kaltformen, Schweißen oder Löten geschlossen ist.

8. Aufdampfcharge (1; 10, 20) nach einem der Ansprüche 5 bis 7, **dadurch gekennzeichnet, dass** die Hülle (3) wenigstens teilweise von einem Tiegel (11; 21) gebildet ist, aus dem heraus die Chargenmenge (2; 14) des Aufdampfmaterials zum Abscheiden verdampft werden kann.

9. Aufdampfcharge (1; 10, 20) nach Anspruch 8, **dadurch gekennzeichnet, dass** an dem Tiegel (11; 21) eine Aufnahmeeinrichtung (13) zum Aufnehmen wenigstens eines Hüllenabschnittes gebildet ist, welcher beim Öffnen der Hülle (3) aufgebrochen wird.

10. Verfahren zum Herstellen einer Aufdampfcharge (1; 10; 20) mit einem Aufdampfmaterial zum Abscheiden auf einem Basismaterial, insbesondere zum Dotieren eines Halbleitermaterials, wobei eine Chargenmenge (2; 14) des Aufdampfmaterials bereitgestellt wird und die Chargenmenge (2; 14) des Aufdampfmaterials mit einer Hülle (3)-luftdicht eingeschlossen wird, **dadurch gekennzeichnet, dass** die Hülle (3) wenigstens teilweise aus einem mittels Erwärmen schmelzbaren Hüllenmaterial gebildet wird, wobei das schmelzbare Hüllenmaterial eine Schmelztemperatur aufweist, welche geringer ist als eine Verdampfungstemperatur des Aufdampfmaterials.

11. Verfahren nach Anspruch 10, **dadurch gekennzeichnet, dass** als das schmelzbare Hüllenmaterial eine Legierung oder ein Metall verwendet wird.

12. Verfahren nach Anspruch 10 oder 11, **dadurch gekennzeichnet, dass** die Hülle (3) mittels Kleben, Kaltformen, Schweißen oder Löten geschlossen wird.

13. Verfahren nach einem der Ansprüche 10 bis 12, **dadurch gekennzeichnet, dass** die Hülle (3) wenigstens teilweise von einem Tiegel (11; 21) gebildet wird, aus dem heraus das Aufdampfinaterial verdampft werden kann.

14. Verfahren nach Anspruch 13, **dadurch gekennzeichnet, dass** an dem Tiegel (11; 21) eine Aufnahmeeinrichtung (13) zum Aufnehmen wenigstens eines Hüllenabschnittes gebildet ist, welcher beim Öffnen der Hülle (3) aufgebrochen wird.

15. Verfahren nach einem der Ansprüche 10 bis 14, **dadurch gekennzeichnet, dass** beim Einschließen der Chargenmenge (2; 14) des Aufdampfmaterials ein die Chargenmenge (2; 14) aufnehmender Raum evakuiert und / oder mit einem Inertgas gefüllt wird.

## Claims

1. Method for depositing a vapour deposition material on a base material, in particular for doping a semiconductor material, in which a vapour deposition batch (1; 10; 20), in which the vapour deposition material is enclosed in an air-tight manner by a shell (3), is introduced into a vapour deposition chamber and the shell (3) is opened in the vapour deposition chamber, so that the vapour deposition material in the vapour deposition chamber then evaporates and is deposited on the base material, wherein the shell (3) is opened by at least partially melting by heating a meltable shell material which at least partially forms the shell (3) at a melting temperature which is lower than an evaporation temperature of the vapour deposition material.

2. The method according to claim 1, **characterized in that** an alloy or a metal is used as the meltable shell material.

3. The method according to any one of the preceding claims, **characterized in that** the shell (3) is opened in the region of a shell section which is formed as a film.

4. The method according to any one of the preceding claims, **characterized in that** a vacuum environment or an inert gas atmosphere is maintained in the vapour deposition chamber during the evaporation and deposition of the vapour deposition material.

5. Vapour deposition batch (1; 10, 20) comprising a vapour deposition material for depositing on a base material, in particular for doping a semiconductor material, wherein a batch quantity (2; 14) of the vapour deposition material is enclosed in an air-tight manner by a shell (3), **characterized in that** the shell (3) is at least partially formed from a meltable shell material for opening in a vapour deposition chamber by heating wherein the meltable shell material has a melting temperature which is lower than an evaporation temperature of the vapour deposition material.

6. The vapour deposition batch (1; 10, 20) according to claim 5, **characterized in that** the meltable shell material is an alloy or a metal.

7. The vapour deposition batch (1; 10, 20) according to claim 5 or 6, **characterized in that** the shell (3) is closed by means of adhesive bonding, cold forming, welding or soldering.

8. The vapour deposition batch (1; 10, 20) according to any one of claims 5 to 7, **characterized in that** the shell (3) is at least partially formed by a crucible (11; 21), from which the batch quantity (2; 14) of the vapour deposition material can be evaporated for deposition.

9. The vapour deposition batch (1; 10, 20) according to claim 8, **characterized in that** a receiving device (13), for receiving at least one shell section which is broken up when the shell (3) is opened, is formed on the crucible (11; 21).

10. Method for producing a vapour deposition batch (1; 10; 20) comprising a vapour deposition material for depositing on a base material, in particular for doping a semiconductor material, wherein a batch quantity (2; 14) of the vapour deposition material is provided and the batch quantity (2; 14) of the vapour deposition material is enclosed in an air-tight manner by a shell (3) **characterized in that** the shell (3) is at least partially formed by heating from a meltable shell material, wherein the meltable shell material has a melting temperature which is lower than an evaporation temperature of the vapour deposition material.

11. The method according to claim 10, **characterized in that** an alloy or a metal is used as the meltable shell material.

12. The method according to claim 10 or 11, **characterized in that** the shell (3) is closed by means of adhesive bonding, cold forming, welding or soldering.

13. The method according to any one of claims 10 to 12, **characterized in that** the shell (3) is at least partially formed by a crucible (11; 21), from which the vapour deposition material can be evaporated.

14. The method according to claim 13, **characterized in that** a receiving device (13), for receiving at least one shell section which is broken up when the shell (3) is opened, is formed on the crucible (11; 21).

15. The method according to any one of claims 10 to 14, **characterized in that** a space which holds the batch quantity (2; 14) is evacuated and/or filled with an inert gas when the batch quantity (2; 14) of the vapour deposition material is enclosed.

## Revendications

1. Procédé pour la séparation d'un matériau de métallisation sur un matériau de base, en particulier pour le dopage d'un matériau semi-conducteur, dans lequel est introduite dans une salle de métallisation une charge de métallisation (1 ; 10 ; 20) dans laquelle le matériau de métallisation est inclus de façon étanche à l'air dans une enveloppe (3) et l'enveloppe (3) est ouverte dans la salle de métallisation de manière à ce que le matériau de métaillisation soit ensuite évaporé dans la salle de métallisation et séparée sur le matériau de base, étant donné que, pour ouvrir l'enveloppe (3), un matériau d'enveloppe fusible constituant au moins partiellement l'enveloppe (3) est fondu au moins partiellement par échauffement à une température de fusion qui est inférieure à une température d'évaporation du matériau de métallisation.

2. Procédé selon la revendication 1, **caractérisé en ce que** le matériau d'enveloppe fusible utilisé est un alliage ou un métal.

3. Procédé selon l'une quelconque des revendications précédentes, **caractérisé en ce que** l'enveloppe (3) s'ouvre au niveau d'une section d'enveloppe sous forme de feuille.

4. Procédé selon l'une quelconque des revendications précédentes, **caractérisé en ce qu'**un environnement sous vide ou une atmosphère de gaz inerte est maintenu dans la salle de métallisation pendant l'évaporation et pendant la séparation du matériau de métallisation.

5. Charge de métallisation (1 ; 10 ; 20) avec un un matériau de métallisation sur un matériau de base, en particulier pour le dopage d'un matériau semi-conducteur, étant donné qu'une quantité de charge (2; 14) du matériau de métallisation est incluse de façon étanche à l'air dans une enveloppe (3), **caractérisée en ce que** l'enveloppe (3) est constituée au moins partiellement d'un matériau d'enveloppe fusible par échauffement pour ouverture dans une salle de métallisation, étant donné que le matériau d'enveloppe fusible a une température de fusion qui est inférieure à une température d'évaporation du matériau de métallisation.

6. Charge de métallisation (1 ; 10 ; 20) selon la revendication 5, **caractérisée en ce que** le matériau d'enveloppe fusible utilisé est un alliage ou un métal.

7. Charge de métallisation (1 ; 10 ; 20) selon l'une quelconque des revendications 5 ou 6, **caractérisée en ce que** l'enveloppe (3) se ferme par collage, formage à froid, soudage ou brasage.

8. Charge de métallisation (1 ; 10 ; 20) selon l'une quelconque des revendications 5 à 7, **caractérisée en ce que** l'enveloppe (3) est constituée au moins partiellement par un creuset (11 ; 21) dans lequel la quantité de charge (2; 14) du matériau de métallisation qui s'y trouve peut être évaporé en vue de la séparation.

9. Charge de métallisation (1 ; 10 ; 20) selon la revendication 8, **caractérisée en ce qu'**est formé sur le creuset (11 ; 21) un dispositif de réception (13) pour la réception d'au moins une section d'enveloppe qui est déchirée à l'ouverture de l'enveloppe (3).

10. Procédé pour la fabrication d'une charge de métallisation (1 ; 10 ; 20) avec un un matériau de métallisation sur un matériau de base, en particulier pour le dopage d'un matériau semi-conducteur, étant donné qu'une quantité de charge (2; 14) du matériau de métallisation est fournie et la quantité de charge (2; 14) du matériau de métallisation est incluse de façon étanche à l'air dans une enveloppe (3), **caractérisée en ce que** l'enveloppe (3) est constituée au moins partiellement d'un matériau d'enveloppe fusible par échauffement pour ouverture dans une salle de métallisation, étant donné que le matériau d'enveloppe fusible a une température de fusion qui est inférieure à une température d'évaporation du matériau de métallisation.

11. Procédé selon la revendication 10, **caractérisé en ce que** le matériau d'enveloppe fusible utilisé est un alliage ou un métal.

12. Procédé selon la revendication 10 ou 11, **caractérisé en ce que** l'enveloppe (3) se ferme par collage, formage à froid, soudage ou brasage.

13. Procédé selon l'une quelconque des revendications 10 à 12, **caractérisé en ce que** l'enveloppe (3) est constituée au moins partiellement par un creuset (11 ; 21) dans lequel le matériau de métallisation qui s'y trouve peut être évaporé.

14. Procédé selon la revendication 13, **caractérisé en ce qu'**est formé sur le creuset (11 ; 21) un dispositif de réception (13) pour la réception d'au moins une section d'enveloppe qui est déchirée à l'ouverture de l'enveloppe (3).

15. Procédé selon l'une quelconque des revendications 10 à 14, **caractérisé en ce que**, lors de l'inclusion de la quantité de charge (2 ; 14) du matériau de métallisation, un espace qui acceuille la quantité de charge (2 ; 14) est évacué et/ou rempli d'un gaz inerte.
